**Europäisches Patentamt**

**European Patent Office**

**Office européen des brevets**

(11) Veröffentlichungsnummer: **0 308 940**
**A2**

## (12) EUROPÄISCHE PATENTANMELDUNG

(21) Anmeldenummer: 88115613.7

(22) Anmeldetag: 22.09.88

(51) Int. Cl.4: **H01L 21/285 , H01L 21/24**

(30) Priorität: 23.09.87 DE 3732043

(43) Veröffentlichungstag der Anmeldung:
**29.03.89 Patentblatt 89/13**

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Zwicknagl, Peter, Dr.**
**Bruckenäcker 5**
**D-7000 Stuttgart 80(DE)**
Erfinder: **Tews, Helmut, Dr.**
**Carl-Orff-Weg 1**
**D-8025 Unterhaching(DE)**
Erfinder: **Humer-Hager, Thomas, Dipl.-Phys.**
**Spindlerstrasse 5**
**D-8000 München 71(DE)**

(54) **Verfahren zur Herstellung von ohmschen Kontakten mit niedrigen Transferwiderständen.**

(57) Verfahren zur Herstellung von ohmschen Kontakten mit niedrigen Transferwiderständen auf dotiertem Halbleitermaterial, wobei mittels Maskentechnik selbstjustierend die Dotierung implantiert (i) und die Metallisierung (4,4a,4b) aufgebracht wird und nach Entfernen der Maskenschicht (2) ein Temperatur-Zeit-Zyklus zum gleichzeitigen Ausheilen der Dotierung und Einlegieren der Metallisierung erfolgt.

FIG 2

FIG 3

EP 0 308 940 A2

Xerox Copy Centre

## Verfahren zur Herstellung von ohmschen Kontakten mit niedrigen Transferwiderständen

Die vorliegende Erfindung betrifft ein Verfahren zur Herstellung von ohmschen Kontakten mit niedrigen Transferwiderständen auf n-leitend dotiertem oder p-leitend dotiertem Halbleitermaterial.

Bei der Herstellung von planaren Heterobipolartransistoren, insbesondere solchen auf GaAs-Basis, stellt sich das Problem, eine Metallisierung für die Kontaktierung der aktiven, d.h. der dotierten Zonen des Transistors mit ausreichend niedrigem Transferwiderstand herzustellen. Bei der Herstellung eines npn-Transistors werden für den Emitter und den Kollektor n-dotierte Bereiche in dem Halbleitersubstrat ausgebildet. Für die Basis wird eine entsprechende p-Dotierung durch Implantation hergestellt. Die Dotierungen müssen durch Erhitzen ausgeheilt, d.h. aktiviert werden. Das geschieht bei hohen Temperaturen entweder durch Langzeitausheilen im Ofen oder durch Kurzzeitausheilen in einer Kurzzeitausheilanlage.

Auf die dotierten Bereiche des Transistors müssen Metallkontakte aufgebracht und einlegiert werden. Bei den meisten bekannten Herstellungsprozessen werden zunächst bei hohen Temperaturen die Implantate ausgeheilt, in einem späteren Prozeßschritt die Metallisierung aufgebracht und diese Metallkontakte danach bei vergleichsweise niedrigen Temperaturen einlegiert. In der Druckschrift M. F. Chang e.a.: "GaAs/(GaAl)As Heterojunction Bipolar Transistors Using a Self-Aligned Substitutional Emitter Process" in IEEE Electron Device Letters EDL-7, 8 bis 10 (1986) ist ein solcher Prozeß beschrieben, bei dem ein Heterobipolartransistor in der Weise hergestellt wird, daß eine Dotierung für die Basis erfolgt und der Emitterbereich dabei als Maskierung dient. Auf diese Weise wird ein in bezug auf den Emitter selbstjustierter Basisbereich hergestellt. Diese Basisdotierung wird ausgeheilt, bevor die zugehörige Metallisierung aufgebracht wird. Die Justage der Basismetallisierung in bezug auf den dotierten Basisbereich und den Emitterbereich erfolgt im Rahmen der Siliziumoxid- bzw. Siliziumnitrid-Maskentechnik.

Ein Prozeß, bei dem Ausheilen von Dotierung und Einlegieren von Metallisierung in einem Temperschritt erfolgen, ist in der Druckschrift K. Ishii e.a.: "High-Temperature Stable $W_5Si_3/In_{0,53}Ga_{0,47}As$ Ohmic Contacts to GaAs for Self-Aligned HBTS" in IEDM 86, S. 274 bis 277 beschrieben. Hier wird zunächst die Metallisierung aufgebracht und diese dann als Maske für die Implantation der Dotierung verwendet. Es wird ein für die betreffende Grunddotierung des Halbleitermaterials hochtemperaturstabile Metallisierung verwendet, so daß das Ausheilen der neuerlichen Dotierung und das Legieren der Metallisierung gleichzeitig in einem Temperschritt erfolgen können. Den Herstellungsverfahren in beiden genannten Druckschriften ist gemeinsam, daß das Ausheilen von Dotierung jeweils für Bereiche erfolgt, die zu dem Zeitpunkt des Temperns noch nicht mit Metallisierungen versehen sind.

Aufgabe der vorliegenden Erfindung ist es, ein selbstjustierendes Verfahren anzugeben, mittels dessen das Ausheilen von n-oder p-Implantaten in III-V-Halbleitermaterial und das Legieren der zugehörigen Metallisierungen in einem einzigen Temperatur-Zeit-Zyklus erfolgen kann. Dabei sollen die erzielten Transferwiderstände nicht größer sein als bei Prozessen, bei denen das Ausheilen der Implantation und das Einlegieren der Kontakte in getrennten Prozeßschritten durchgeführt wird.

Diese Aufgabe wird bei dem erfindungsgemäßen Verfahren durch die Merkmale des Anspruchs 1 gelöst.

Das erfindungsgemäße Verfahren macht von der Tatsache Gebrauch, daß hochtemperaturstabile Metallisierungen für III-V-Halbleitermaterial existieren. Insbesondere für GaAs-Substrate lassen sich für n-Dotierung und für p-Dotierung Metallisierungen angeben, die auf die Oberfläche entsprechend dotierter Bereiche aufgebracht und bei Temperaturen, die dem Ausheilzyklus der Dotierungen entsprechen, einlegiert werden.

Der Kern des erfindungsgemäßen Verfahrens ist dabei darin zu sehen, daß anders als im Stand der Technik ein solcher gemeinsamer Ausheil- und Einlegierschritt für dotierte Bereiche und deren zugehöriger Metallisierung durchgeführt wird. Die übliche Fotomaskentechnik kann daher für einen nachträglich zu dotierenden Bereich sowie die darauf aufzubringende Metallisierung angewandt werden. Daher ist es möglich, den erfindungsgemäß vorgeschlagenen Herstellungsprozeß in selbstjustierender Weise durchzuführen.

Die Metallisierungen enthalten eines oder mehrere Metalle die nacheinander aufgebracht und anschließend einlegiert werden. Für die Kontaktierung von für n-Leitung dotierte Bereiche sind in der Literatur unter anderem Titansilizid, Wolframsilizid, Molybdänsilizid, Tantalsilizid (US-PS 4 566 021), Wolframnitrid, Tantalnitrid, Molbydännitrid, Titannitrid, Zirkonnitrid, Niobnitrid, Vanadiumnitrid (US-PS 45 74 298), Lanthanhexaborid (Jpn. J. Appl. Phys. 25, L 767 bis L 769 (1986)) und Wolframborid (Patentanmeldung P 37 26 717) angegeben. Dabei handelt es sich entweder um Legierungen des betreffenden Metalles mit Silizium, Stickstoff oder Bor oder um stöchiometrische Verbindungen zwischen den beiden Elementen. Ferner kommen auch intermetallische Legierungen und Verbindungen und Schichten aus reinem Metall in Frage. Für die Bereiche, die für p-Leitung dotiert sind, werden nach dem erfindungsgemäßen Verfahren bevorzugt solche Metallisierungen eingesetzt, die Titan enthalten. Es werden dabei entweder erstens Titan, zweitens Platin und drittens Titan oder erstens Titan, zweitens Platin und drittens Gold oder erstens Titan, zweitens Platin, drittens Gold, viertens Titan und fünftens Platin aufgebracht und anschließend einlegiert. Eine mögliche Metallisierung läßt sich auch durch aufeinanderfolgendes Aufbringen von Germanium, Gold, Chrom und wieder Gold herstellen. Mit einer solchen Germanium-Gold-Chrom-Gold-Legierung erhält man auf p-dotierten Bereichen hinreichend niedrige Transferwiderstände nur bei Legierzeiten zwischen fünf und sieben Minuten. Die Temperatur-Zeit-Grenzen für die Herstellung von Metallisierungen mit ausreichend niedrigen Transferwiderständen auf p-dotierten Bereichen sind bei Verwendung von Titan-Platin-Gold-Legierungen sehr viel weiter als bei der Germanium-Gold-Chrom-Gold-Metallisierung, weshalb die Titan enthaltenden Legierungen für die Metallisierung von p-dotierten Bereichen, insbesondere für die Herstellung von Heterobipolartransistoren nach dem hier vorgeschlagenen Herstellungsverfahren wesentlich besser geeignet sind.

Die Figuren zeigen die fünf wesentlichen Schritte bei dem erfindungsgemäßen Prozeßablauf.

Figur 1 zeigt das Substrat mit der aufgebrachten Maskenschicht.

Figur 2 zeigt das Substrat mit der Maskenschicht und der Implantation eines dotierten Bereiches.

Figur 3 zeigt das Substrat mit Maskenschicht, dotiertem Bereich und der darauf abgeschiedenen hochtemperaturfesten Metallisierung.

Figur 4 zeigt das Substrat mit dem dotierten Bereich und der auf diesem Bereich aufgebrachten Metallisierung nach Entfernen der Maskenschicht.

Figur 5 zeigt das Substrat mit dem dotierten Bereich und der Metallisierung im Aufbau nach Figur 4 nach dem Temperprozeß zum Ausheilen der Implantate und zum Einlegieren der Metallisierung.

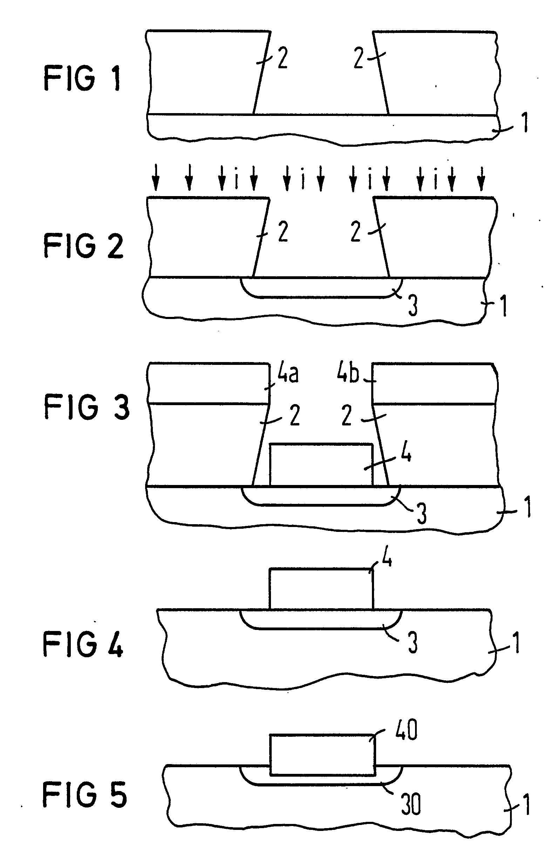

Bei dem erfindungsgemäßen Verfahren wird in einem ersten Schritt auf der obersten Halbleiterschicht 1 eines herzustellenden Bauelementes mit einem Substrat aus III-V-Halbleitermaterial, z.B. GaAs, eine Maskenschicht 2 aufgebracht. Die Flanken dieser Maskenschicht 2, die z.B. aus einer oder mehreren Lackmaskenschichten bestehen kann, werden zweckmäßigerweise überhängend ausgebildet (Fig. 1). In dem nächsten Verfahrensschritt erfolgt die Implantation i (Fig. 2) zur Ausbildung von p-dotierten bzw. n-dotierten Bereichen 3.

Darauf folgt als dritter Schritt des Prozesses das Aufdampfen der Metallisierung 4, 4a, 4b in der Richtung, die in Fig. 2 durch die mit i gekennzeichneten Pfeile dargestellt ist. Auf diese Weise erhält man auf jedem dotierten Bereich 3 eine Metallisierung 4, die wegen der Verwendung derselben Maskenschicht 2 selbstjustiert bezüglich des jeweiligen dotierten Bereiches 3 ist. Das Ergebnis der Abscheidung dieser Metallisierung 4,4a,4b ist in Fig. 3 dargestellt. In einem vierten Schritt wird mittels Abhebetechnik die Maskenschicht 2 mit den darauf befindlichen Teilen der Metallisierung 4a, 4b entfernt. Das Bauteil besteht jetzt aus dem Substrat mit einer oder mehreren Halbleiterschichten, deren oberste Halbleiterschicht 1 dotierte Bereiche 3 mit jeweiliger Metallisierung 4 aufweist (Fig. 4). Abschließend werden in einem fünften Schritt die Implantate der dotierten Bereiche 3 und die darauf befindlichen Metallisierungen 4 gleichzeitig mit demselben Temperatur-Zeit-Zyklus z.B. in einer Kurzzeit-Ausheilanlage behandelt, um die Implantate auszuheilen und die Metallisierung einzulegieren. Bei diesem Temperprozeß ist die Temperatur als Funktion der Zeit so zu wählen, daß die Transferwiderstände der durch die einlegierten Metallisierungen 40 gebildeten Kontakte nicht höher als durch die vorgesehene Anwendung des Bauteils bestimmte Werte annehmen. Im Fall einer Ti/Pt/Au- oder Ti/Pt/Ti-Metallisierung auf GaAs-Basis liefert eine Erwärmung auf eine Temperatur zwischen $850°$ C und $900°$ C für maximal 3s, ideal 2s, Transferwiderstände, die z.B. für die Funktion von auf diese Weise hergestellten Heterobipolartransistoren ausreichend niedrig sind. Das fertige Bauelement mit Substrat 1 und ausgeheiltem dotiertem Bereich 30 mit darauf befindlicher einlegierter Metallisierung 40 zeigt Fig. 5.

## Ansprüche

1. Verfahren zur Herstellung von ohmschen Kontakten mit niedrigen Transferwiderständen auf einer Halbleiterschicht (1) eines Bauelementes mit einem Substrat aus III-V-Halbleitermaterial, wobei zunächst die Halbleiterschicht (1) mit einer Maskenschicht (2) versehen wird und anschließend eine Implantation (i) zur Herstellung mindestens eines dotierten Bereiches (3) erfolgt,

**dadurch gekennzeichnet,**

- daß in einem ersten weiteren Schritt eine für das Material der Halbleiterschicht (1) mit der im vorhergehenden Schritt implantierten Dotierung bezogen auf einen nachfolgenden Temperatur-Zeit-Zyklus hochtemperaturfeste Metallisierung (4,4a, 4b) aufgebracht wird,

- daß in einem zweiten weiteren Schritt mittels Abhebetechnik die Maskenschicht (2) mit dem darauf befindlichen Teil der Metallisierung (4a,4b) entfernt wird und

- daß in einem dritten weiteren Schritt ein Temperatur-Zeit-Zyklus durchgeführt wird, wobei gleichzeitig die Implantate ausgeheilt werden und die Metallisierung (4;40) der dotierten Bereiche (3;30) einlegiert wird.

2. Verfahren nach Anspruch 1,

**dadurch gekennzeichnet,**

daß das Ausheilen der Implantate und das Einlegieren der Metallisierung (4;40) in einer Kurzzeitausheilanlage erfolgen.

3. Verfahren nach Anspruch 1 oder 2,

**dadurch gekennzeichnet,**

daß das Substrat GaAs ist.

4. Verfahren nach einem der Ansprüche 1 bis 3,

**dadurch gekennzeichnet,**

daß die Dotierung für n-Leitung erfolgt.

5. Verfahren nach einem der Ansprüche 1 bis 3,

**dadurch gekennzeichnet,**

daß die Dotierung für p-Leitung erfolgt.

6. Verfahren nach einem der Ansprüche 1 bis 3,

**dadurch gekennzeichnet,**

daß mit den angegebenen Verfahrensschritten sowohl n-dotierte als auch p-dotierte, mit Metallisierung versehene Bereiche der Halbleiterschicht (1) hergestellt werden.

7. Verfahren nach Anspruch 4,

**dadurch gekennzeichnet,**

daß die Metallisierung mit einem Metallsilizid, einem Metallnitrid oder einem Metallborid erfolgt.

8. Verfahren nach Anspruch 7,

**dadurch gekennzeichnet,**

daß das Metall für die Metallisierung mindestens eines aus der Gruppe von Titan, Wolfram, Tantal, Molybdän, Zirkon, Niob und Vanadium ist.

9. Verfahren nach Anspruch 5,

**dadurch gekennzeichnet,**

daß die Metallisierung nacheinander aufgebrachtes Titan, Platin und Titan ist.

10. Verfahren nach Anspruch 5,

**dadurch gekennzeichnet,**

daß die Metallisierung nacheinander aufgebrachtes Titan, Platin und Gold ist.

11. Verfahren nach Anspruch 5,

**dadurch gekennzeichnet,**

daß die Metallisierung nacheinander aufgebrachtes Titan, Platin, Gold, Titan und Platin ist.

12. Verfahren nach einem der Ansprüche 1 bis 11,

**dadurch gekennzeichnet,**

daß die mit dem ohmschen Kontakt zu versehende Halbleiterschicht (1) eine oberste Schicht einer wie für Heterobipolartransistoren üblichen Schichtfolge bildet.

FIG 1

FIG 2

FIG 3

FIG 4

FIG 5